# EUROPEAN PATENT APPLICATION

(11) **EP 2 750 210 A2**
(43) Date of publication of application: **02.07.2014**
(21) Application number: 13197119.4
(22) Date of filing: 13.12.2013
(51) Int. Cl.: H01L 33/52, B29C 43/18, H01L 33/56

(54) **Encapsulating sheet**

(30) Priority: 26.12.2012 JP 2012282902
(71) Applicant: NITTO DENKO CORPORATION, Ibaraki-shi, Osaka 567-8680 (JP)
(72) Inventor: Matsuda, Hirokazu, Osaka, 567-8680 (JP); Ona, Haruka, Osaka, 567-8680 (JP)
(74) Representative: HOFFMANN EITLE

(57) **Abstract**

An encapsulating sheet, for encapsulating an optical semiconductor element, includes an embedding layer for embedding the optical semiconductor element, a covering layer disposed at one side in a thickness direction with respect to the embedding layer, and a barrier layer interposed between the embedding layer and the covering layer; having a thickness of 50 µm or more and 1,000 µm or less; and for suppressing a transfer of a component contained in the covering layer to the embedding layer.

## Description

### CROSS-REFERENCE TO RELATED APPLICATION

The present application claims priority from Japanese Patent Application No. 2012-282902 filed on December 26, 2012, the contents of which are hereby incorporated by reference into this application.

### BACKGROUND OF THE INVENTION

### Field of the Invention

The present invention relates to an encapsulating sheet, to be specific, to an encapsulating sheet used for optical use.

### Description of Related Art

As a light emitting device that is capable of emitting high energy light, a white light emitting device (an optical semiconductor device) has been conventionally known.

For example, an optical semiconductor device obtained in the following manner has been proposed (ref: for example, Japanese Unexamined Patent Publication No. 2012-I29361). That is, a wavelength conversion layer that is formed from a silicone elastomer and an inorganic high thermal conductive layer that is made of a glass having a thickness of 35 µm are sequentially placed on a bottom portion of a concave metal mold. Thereafter, another silicone elastomer is allowed to fill to form an encapsulating resin layer; then, a substrate on which a blue LED chip is mounted is placed on the obtained laminate so that the encapsulating resin layer is opposed to the blue LED chip; the resulting product is encapsulated by heating; and then, the metal mold is opened to remove the optical semiconductor device.

### SUMMARY OF THE INVENTION

In the laminate that is made of the wavelength conversion layer, the inorganic high thermal conductive layer, and the encapsulating resin layer in Japanese Unexamined Patent Publication No. 2012-129361, however, the silicone elastomer is allowed to fill the concave metal mold, so that the encapsulating resin layer is formed and thereafter, the blue LED chip is individually embedded in the encapsulating resin layer. In this way, there is a disadvantage that the improvement in the production efficiency of the optical semiconductor device is not capable of being sufficiently achieved.

In the above-described laminate, when a catalyst component that is contained in the wavelength conversion layer, which is already formed, is transferred to the encapsulating resin layer, which is not yet formed (that is, not heated), the encapsulating resin layer is easily cured before it comes into contact with the blue LED chip and thus, it becomes difficult to surely embed the blue LED chip in the encapsulating resin layer. Accordingly, the above-described transfer is required to be suppressed in the laminate.

The laminate is also required to have an excellent strength.

In the laminate in Japanese Unexamined Patent Publication No. 2012-129361, however, the inorganic high thermal conductive layer is not sufficient to suppress the above-described transfer and furthermore, the strength of the laminate is not sufficient, so that there is a disadvantage that an optical semiconductor device having excellent reliability is not capable of being obtained.

It is an object of the present invention to provide an encapsulating sheet that is capable of suppressing a transfer of a component contained in a covering layer to an embedding layer, has an excellent strength, and is capable of efficiently producing an optical semiconductor device.

An encapsulating sheet of the present invention, for encapsulating an optical semiconductor element, includes an embedding layer for embedding the optical semiconductor element, a covering layer disposed at one side in a thickness direction with respect to the embedding layer, and a barrier layer interposed between the embedding layer and the covering layer; having a thickness of 50 µm or more and 1,000 µm or less; and for suppressing a transfer of a component contained in the covering layer to the embedding layer.

When the optical semiconductor element is encapsulated by the encapsulating sheet, the optical semiconductor element is capable of being collectively encapsulated, so that the optical semiconductor device is capable of being obtained with excellent production efficiency.

The encapsulating sheet includes the barrier layer having a thickness of 50 µm or more and 1,000 µm or less so as to suppress the transfer of the component contained in the covering layer to the embedding layer, so that the transfer of the component contained in the covering layer to the embedding layer is suppressed and the curing of the embedding layer before embedding the optical semiconductor element is capable of being suppressed. Thus, the optical semiconductor element is capable of being surely embedded by the embedding layer before curing and thereafter, when the embedding layer is cured, the optical semiconductor element is capable of being surely encapsulated. Therefore, the optical semiconductor device having excellent dimension stability is capable of being obtained.

In addition, in the encapsulating sheet, the barrier layer has a thickness of 50 µm or more and 1,000 µm or less, so that an excellent strength is ensured and the thinning of the encapsulating sheet is capable of being achieved. Thus, when the optical semiconductor element is encapsulated by the encapsulating sheet, the strength and the reliability of the optical semiconductor device are capable of being improved even with the thin encapsulating sheet.

In the encapsulating sheet of the present invention, it is preferable that the embedding layer is formed from a thermosetting resin in a B-stage state and the covering layer is formed from a thermosetting resin in a C-stage state.

In the encapsulating sheet, the embedding layer is formed from the thermosetting resin in a B-stage state, so that the optical semiconductor element is capable of being surely embedded by the flexible embedding layer. The covering layer is formed from the thermosetting resin in a C-stage state, so that the strength of the encapsulating sheet is capable of being further improved.

In the encapsulating sheet of the present invention, it is preferable that the ratio of the thickness of the barrier layer to that of the embedding layer is 0.10 or more and 1.00 or less.

In the encapsulating sheet, the ratio of the thickness of the barrier layer to that of the embedding layer is 0.10 or more and 1.00 or less, so that the barrier properties are improved, while the optical semiconductor element is capable of being surely embedded with the improvement of the strength of the encapsulating sheet and the achievement of the thinning thereof.

### BRIEF DESCRIPTION OF THE DRAWINGS

FIG. 1 shows a sectional view of one embodiment of an encapsulating sheet of the present invention.
FIG. 2 shows process drawings for illustrating a method for producing an optical semiconductor device by encapsulating an optical semiconductor element by the encapsulating sheet in FIG. 1:
FIG. 2 (a) illustrating a step of preparing the encapsulating sheet and a substrate and
FIG. 2 (b) illustrating a step of encapsulating the optical semiconductor element by the encapsulating sheet.

### DETAILED DESCRIPTION OF THE INVENTION

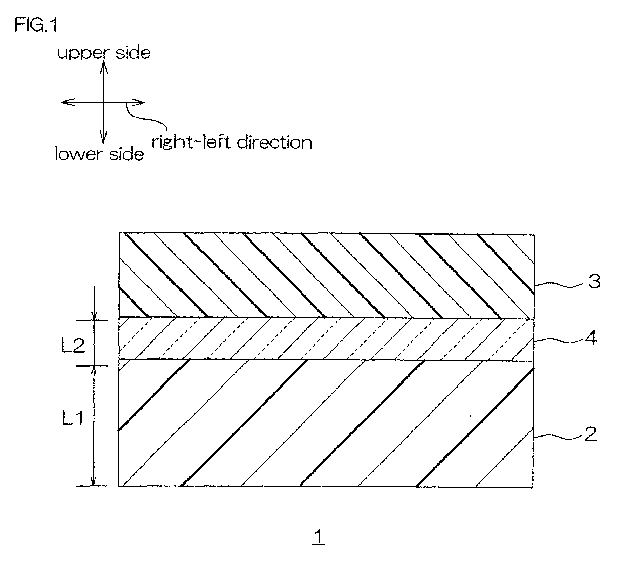

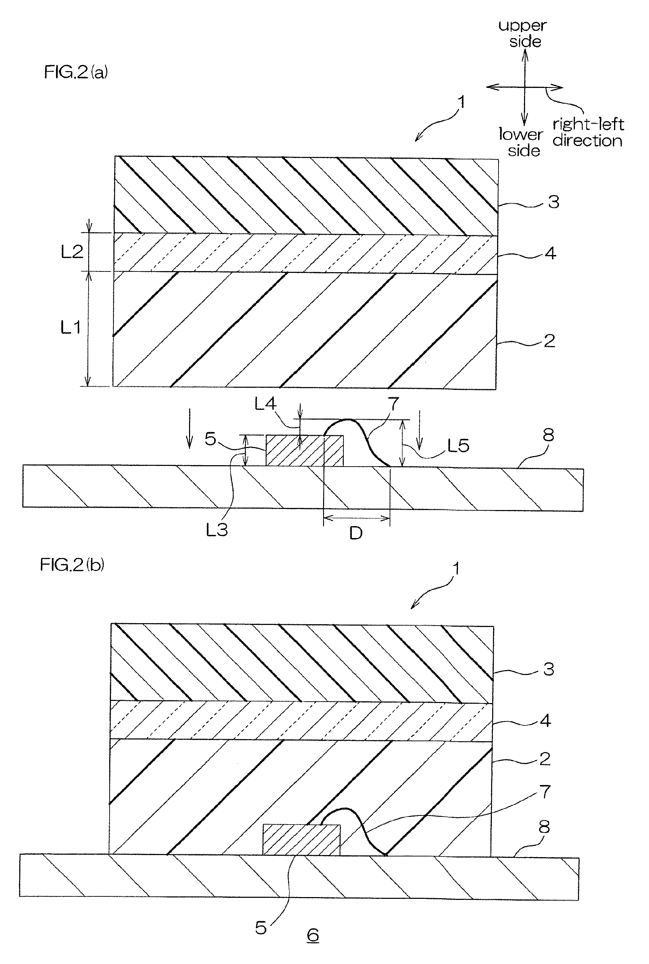

In FIG. 1, the up-down direction of the paper surface is referred to as an up-down direction (a thickness direction, a first direction); the right-left direction of the paper surface is referred to as a right-left direction (a second direction); and the paper thickness direction is referred to as a depth direction (a third direction). In FIG. 2, directions and direction arrows are in conformity with the above-described directions and the direction arrows in FIG. 1.

In FIG. 1, an encapsulating sheet 1 is an encapsulating sheet that encapsulates an optical semiconductor element 5 (ref: FIG. 2) to be described later and is formed into a generally rectangular flat plate shape extending in a plane direction (a direction perpendicular to the thickness direction, that is, the right-left direction and a front-rear direction). The encapsulating sheet 1 includes an embedding layer 2, a covering layer 3 that is provided at spaced intervals to the upper side (one side in the thickness direction) of the embedding layer 2, and a barrier layer 4 that is interposed between the embedding layer 2 and the covering layer 3. That is, in the encapsulating sheet 1, the embedding layer 2 is provided below the barrier layer 4 and the covering layer 3 is provided on the barrier layer 4.

The embedding layer 2 is a layer that embeds the optical semiconductor element 5 (ref: FIG. 2) and is formed from a resin into a generally sheet shape. The embedding layer 2 is provided at the lowermost side in the encapsulating sheet 1.

The resin is formed from, for example, an encapsulating resin composition or the like. An example of the encapsulating resin composition includes a known transparent resin used for embedding and encapsulating the optical semiconductor element 5 (described later, ref: FIG. 2 (b)). Examples of the transparent resin include a thermosetting resin such as a silicone resin, an epoxy resin, and a urethane resin and a thermoplastic resin such as an acrylic resin, a styrene resin, a polycarbonate resin, and a polyolefin resin.

These transparent resins can be used alone or in combination.

Of the transparent resins, preferably, a thermosetting resin is used, or more preferably, in view of durability, heat resistance, and light resistance, a silicone resin is used.

Of the encapsulating resin compositions, preferably, a resin composition containing a silicone resin (hereinafter, referred to as a silicone resin composition) is used.

Examples of the silicone resin composition include a condensation and addition reaction curable type silicone resin composition, a hetero atom-containing modified silicone resin composition, an addition reaction curable type silicone resin composition, and an inorganic oxide-containing silicone resin composition.

Of the silicone resin compositions, in view of flexibility of the embedding layer 2 before curing and strength thereof after curing, preferably, a condensation and addition reaction curable type silicone resin composition is used.

The condensation and addition reaction curable type silicone resin composition is a silicone resin composition that is capable of being subjected to a condensation reaction (to be specific, a silanol condensation reaction) and an addition reaction (to be specific, a hydrosilylation reaction). To be more specific, the condensation and addition reaction curable type silicone resin composition is a silicone resin composition that is capable of being subjected to a condensation reaction to be brought into a semi-cured state (a B-stage state) by heating and next, being subjected to an addition reaction to be brought into a cured state (a completely cured state, a C-stage state) by further heating.

An example of the condensation reaction includes a silanol condensation reaction. Examples of the addition reaction include an epoxy ring-opening reaction and the hydrosilylation reaction.

The B-stage state is a state between an A-stage state in which a silicone resin composition is in a liquid state and a C-stage state in which the silicone resin composition is completely cured. Also, the B-stage state is a state in which the curing and the gelation of the silicone resin composition are slightly progressed and the elastic modulus thereof is smaller than that in a C-stage state.

The condensation and addition reaction curable type silicone resin composition contains, for example, a polysiloxane containing silanol groups at both ends, an ethylenically unsaturated hydrocarbon group-containing silicon compound (hereinafter, referred to as an ethylenic silicon compound), an epoxy group-containing silicon compound, and an organohydrogensiloxane.

The polysiloxane containing silanol groups at both ends, the ethylenic silicon compound, and the epoxy group-containing silicon compound are a condensation material (a material subjected to a condensation reaction) and the ethylenic silicon compound and the organohydrogensiloxane are an addition material (a material subjected to an addition reaction).

The polysiloxane containing silanol groups at both ends is an organosiloxane that contains silanol groups (SiOH groups) at both ends of a molecule and to be specific, is represented by the following general formula (1).

General Formula (1): 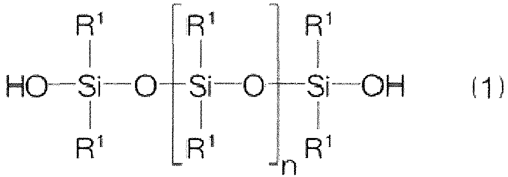 (where, in general formula (1), R¹ represents a monovalent hydrocarbon group selected from a saturated hydrocarbon group and an aromatic hydrocarbon group. "n" represents an integer of 1 or more.)

In the above-described general formula (1), in the monovalent hydrocarbon group represented by R¹, examples of the saturated hydrocarbon group include a straight chain or branched chain alkyl group having 1 to 6 carbon atoms (such as a methyl group, an ethyl group, a propyl group, an isopropyl group, a butyl group, an isobutyl group, a pentyl group, and a hexyl group) and a cycloalkyl group having 3 to 6 carbon atoms (such as a cyclopentyl group and a cyclohexyl group).

In the above-described general formula (1), in the monovalent hydrocarbon group represented by R¹, an example of the aromatic hydrocarbon group includes an aryl group having 6 to 10 carbon atoms (such as a phenyl group and a naphthyl group).

In the above-described general formula (1), R¹s may be the same or different from each other. Preferably, R¹s are the same.

As the monovalent hydrocarbon group, preferably, an alkyl group having 1 to 6 carbon atoms and an aryl group having 6 to 10 carbon atoms are used, more preferably, in view of transparency, thermal stability, and light resistance, a methyl group and a phenyl group are used, or further more preferably, a methyl group is used.

In the above-described general formula (1), "n" is preferably, in view of stability and/or handling ability, an integer of 1 to 10,000, or more preferably an integer of 1 to 1,000.

"n" in the above-described general formula (1) is calculated as an average value.

To be specific, examples of the polysiloxane containing silanol groups at both ends include a polydimethylsiloxane containing silanol groups at both ends, a polymethylphenylsiloxane containing silanol groups at both ends, and a polydiphenylsiloxane containing silanol groups at both ends.

These polysiloxanes containing silanol groups at both ends can be used alone or in combination.

Of the polysiloxanes containing silanol groups at both ends, preferably, a polydimethylsiloxane containing silanol groups at both ends is used.

A commercially available product can be used as the polysiloxane containing silanol groups at both ends. A polysiloxane containing silanol groups at both ends synthesized in accordance with a known method can be also used.

The polysiloxane containing silanol groups at both ends has a number average molecular weight of, in view of stability and/or handling ability, for example, 100 or more, or preferably 200 or more, and of, for example, 1,000,000 or less, or preferably 100,000 or less. The number average molecular weight is calculated by conversion based on standard polystyrene with a gel permeation chromatography. The number average molecular weight of a material, other than the polysiloxane containing silanol groups at both ends, to be described later, is also calculated in the same manner as that described above.

The silanol group equivalent in the polysiloxane containing silanol groups at both ends is, for example, 0.002 mmol/g or more, or preferably 0.02 mmol/g or more, and is, for example, 25 mmol/g or less.

The mixing ratio of the polysiloxane containing silanol groups at both ends with respect to 100 parts by mass of the condensation material is, for example, 1 part by mass or more, preferably 50 parts by mass or more, or more preferably 80 parts by mass or more, and is, for example, 99.99 parts by mass or less, preferably 99.9 parts by mass or less, or more preferably 99.5 parts by mass or less.

The ethylenic silicon compound is a silane compound having both an ethylenically unsaturated hydrocarbon group and a leaving group in a silanol condensation reaction and to be specific, is represented by the following general formula (2).

General Formula (2):

R²-Si-(X¹)₃ (2)

(where, in general formula (2), R² represents a monovalent ethylenically unsaturated hydrocarbon group. X¹ represents a halogen atom, an alkoxy group, a phenoxy group, or an acetoxy group. X¹s may be the same or different from each other.)

In the above-described general formula (2), examples of the ethylenically unsaturated hydrocarbon group represented by R² include a substituted or unsubstituted ethylenically unsaturated hydrocarbon group. Examples thereof include an alkenyl group and a cycloalkenyl group.

An example of the alkenyl group includes an alkenyl group having 2 to 10 carbon atoms such as a vinyl group, an allyl group, a propenyl group, a butenyl group, a pentenyl group, a hexenyl group, a heptenyl group, and an octenyl group.

An example of the cycloalkenyl group includes a cycloalkenyl group having 3 to 10 carbon atoms such as a cyclohexenyl group and a norbornenyl group.

As the ethylenically unsaturated hydrocarbon group, in view of reactivity with a hydrosilyl group, preferably, an alkenyl group is used, more preferably, an alkenyl group having 2 to 5 carbon atoms is used, or particularly preferably, a vinyl group is used.

X¹ in the above-described general formula (2) is a leaving group in the silanol condensation reaction. SiX¹ group in the above-described general formula (2) is a reactive functional group in the silanol condensation reaction.

In the above-described general formula (2), examples of the halogen atom represented by X¹ include a bromine atom, a chlorine atom, a fluorine atom, and an iodine atom.

In the above-described general formula (2), examples of the alkoxy group represented by X¹ include an alkoxy group containing a straight chain or branched chain alkyl group having 1 to 6 carbon atoms (such as a methoxy group, an ethoxy group, a propoxy group, an isopropoxy group, a butoxy group, an isobutoxy group, a pentyloxy group, and a hexyloxy group) and an alkoxy group containing a cycloalkyl group having 3 to 6 carbon atoms (such as a cyclopentyloxy group and a cyclohexyloxy group).

In the above-described general formula (2), X¹s may be the same or different from each other. Preferably, X¹s are the same.

Of the X¹s in the above-described general formula (2), preferably, an alkoxy group is used, or more preferably, a methoxy group is used.

Examples of the ethylenic silicon compound include a trialkoxysilane containing an ethylenically unsaturated hydrocarbon group, a trihalogenated silane containing an ethylenically unsaturated hydrocarbon group, a triphenoxysilane containing an ethylenically unsaturated hydrocarbon group, and a triacetoxysilane containing an ethylenically unsaturated hydrocarbon group.

These ethylenic silicon compounds can be used alone or in combination.

Of the ethylenic silicon compounds, preferably, a trialkoxysilane containing an ethylenically unsaturated hydrocarbon group is used.

To be specific, examples of the trialkoxysilane containing an ethylenically unsaturated hydrocarbon group include a vinyltrialkoxysilane such as a vinyltrimethoxysilane, a vinyltriethoxysilane, and a vinyltripropoxysilane; an allyltrimethoxysilane; a propenyltrimethoxysilane; a butenyltrimethoxysilane; and a cyclohexenyltrimethoxysilane.

Of the trialkoxysilanes containing an ethylenically unsaturated hydrocarbon group, preferably, a vinyltrialkoxysilane is used, or more preferably, a vinyltrimethoxysilane is used.

The mixing ratio of the ethylenic silicon compound with respect to 100 parts by mass of the condensation material is, for example, 0.01 to 90 parts by mass, preferably 0.01 to 50 parts by mass, or more preferably 0.01 to 10 parts by mass.

A commercially available product can be used as the ethylenic silicon compound. An ethylenic silicon compound synthesized in accordance with a known method can be also used.

The epoxy group-containing silicon compound is a silane compound having both an epoxy group and a leaving group in a silanol condensation reaction and to be specific, is represented by the following general formula (3).

General Formula (3):

R³-Si-(X²)₃ (3)

(where, in general formula (3), R³ represents a group having an epoxy structure. X² represents a halogen atom, an alkoxy group, a phenoxy group, or an acetoxy group. X²s may be the same or different from each other.)

In the above-described general formula (3), examples of the group having an epoxy structure represented by R³ include an epoxy group, a glycidyl ether group, and an epoxycycloalkyl group such as an epoxycyclohexyl group.

Of the groups having an epoxy structure, preferably, a glycidyl ether group is used. To be specific, the glycidyl ether group is a glycidoxyalkyl group represented by the following general formula (4).

General Formula (4): 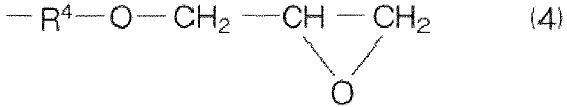 (where, in general formula (4), R⁴ represents a divalent hydrocarbon group selected from a saturated hydrocarbon group and an aromatic hydrocarbon group.)

In the above-described general formula (4), in the divalent hydrocarbon group represented by R⁴, examples of the saturated hydrocarbon group include an alkylene group having 1 to 6 carbon atoms (such as a methylene group, an ethylene group, a propylene group, and a butylene group) and a cycloalkylene group having 3 to 8 carbon atoms (such as a cyclopentylene group and a cyclohexylene group).

In the above-described general formula (4), in the divalent hydrocarbon group represented by R⁴, an example of the aromatic hydrocarbon group includes an arylene group having 6 to 10 carbon atoms (such as a phenylene group and a naphthylene group).

As the divalent hydrocarbon group, preferably, an alkylene group having 1 to 6 carbon atoms is used, or more preferably, a propylene group is used.

To be specific, examples of the glycidyl ether group include a glycidoxymethyl group, a glycidoxyethyl group, a glycidoxypropyl group, a glycidoxycyclohexyl group, and a glycidoxyphenyl group.

Of the glycidyl ether groups, preferably, a glycidoxypropyl group is used.

X² in the above-described general formula (3) is a leaving group in the silanol condensation reaction. SiX² group in the above-described general formula (3) is a reactive functional group in the silanol condensation reaction.

In the above-described general formula (3), an example of the halogen atom represented by X² includes the same halogen atom as that represented by X¹ in the above-described general formula (2).

In the above-described general formula (3), an example of the alkoxy group represented by X² includes the same alkoxy group as that represented by X¹ in the above-described general formula (2).

In the above-described general formula (3), X²s may be the same or different from each other. Preferably, X²s are the same.

As X² in the above-described general formula (3), preferably, an alkoxy group is used, or more preferably, a methoxy group is used.

Examples of the epoxy group-containing silicon compound include an epoxy group-containing trialkoxysilane, an epoxy group-containing trihalogenated silane, an epoxy group-containing triphenoxysilane, and an epoxy group-containing triacetoxysilane.

These epoxy group-containing silicon compounds can be used alone or in combination.

Of the epoxy group-containing silicon compounds, preferably, an epoxy group-containing trialkoxysilane is used.

To be specific, examples of the epoxy group-containing trialkoxysilane include a glycidoxyalkyltrimethoxysilane such as a glycidoxymethyltrimethoxysilane, a (2-glycidoxyethyl)trimethoxysilane, and a (3-glycidoxypropyl)trimethoxysilane; a (3-glycidoxypropyl)triethoxysilane; a (3-glycidoxypropyl)tripropoxysilane; and a (3-glycidoxypropyl)triisopropoxysilane.

Of the epoxy group-containing trialkoxysilanes, preferably, a glycidoxyalkyltrimethoxysilane is used, or more preferably, a (3-glycidoxypropyl)trimethoxysilane is used.

The mixing ratio of the epoxy group-containing silicon compound with respect to 100 parts by mass of the condensation material is, for example, 0.01 to 90 parts by mass, preferably 0.01 to 50 parts by mass, or more preferably 0.01 to 1 parts by mass.

A commercially available product can be used as the epoxy group-containing silicon compound. An epoxy group-containing silicon compound synthesized in accordance with a known method can be also used.

The molar ratio (SiOH/(SiX¹ + SiX²)) of the silanol group (the SiOH group) in the polysiloxane containing silanol groups at both ends to the reactive functional group (the SiX¹ group and the SiX² group) in the ethylenic silicon compound and the epoxy group-containing silicon compound is, for example, 20/1 or less, or preferably 10/1 or less, and is, for example, 0.2/1 or more, preferably 0.5/1 or more, or particularly preferably substantially 1/1.

When the molar ratio is above the above-described range, there may be a case where a material in a semi-cured state (a semi-cured material) having an appropriate toughness is not obtained when the condensation and addition reaction curable type silicone resin composition is brought into a semi-cured state. On the other hand, when the molar ratio is below the above-described range, there may be a case where the mixing proportion of the ethylenic silicon compound and the epoxy group-containing silicon compound is excessively large, so that the heat resistance of the embedding layer 2 to be obtained is reduced.

When the molar ratio is within the above-described range (preferably, substantially 1/1), the silanol group (the SiOH group) in the polysiloxane containing silanol groups at both ends, and the reactive functional group (the SiX¹ group) in the ethylenic silicon compound and the reactive functional group (the SiX² group) in the epoxy group-containing silicon compound can be subjected to a condensation reaction neither too much nor too little.

The molar ratio of the ethylenic silicon compound to the epoxy group-containing silicon compound is, for example, 10/90 or more, preferably 50/50 or more, or more preferably 80/20 or more, and is, for example, 99/1 or less, preferably 97/3 or less, or more preferably 95/5 or less.

When the molar ratio is within the above-described range, there is an advantage that the adhesive properties of a cured material are capable of being improved, while the strength thereof is ensured.

The organohydrogensiloxane is an organopolysiloxane having, in one molecule, at least two hydrosilyl groups without containing an ethylenically unsaturated hydrocarbon group.

To be specific, examples of the organohydrogensiloxane include an organopolysiloxane containing a hydrogen atom in its side chain and an organopolysiloxane containing hydrogen atoms at both ends.

The organopolysiloxane containing a hydrogen atom in its side chain is an organohydrogensiloxane having a hydrogen atom as a side chain that branches off from the main chain. Examples thereof include a methylhydrogenpolysiloxane, a dimethylpolysiloxane-co-methylhydrogenpolysiloxane, an ethylhydrogenpolysiloxane, and a methylhydrogenpolysiloxane-co-methylphenylpolysiloxane.

The organopolysiloxane containing a hydrogen atom in its side chain has a number average molecular weight of, for example, 100 to 1,000,000, or preferably 100 to 100,000.

The organopolysiloxane containing hydrogen atoms at both ends is an organohydrogensiloxane having hydrogen atoms at both ends of the main chain. Examples thereof include a polydimethylsiloxane containing hydrosilyl groups at both ends, a polymethylphenylsiloxane containing hydrosilyl groups at both ends, and a polydiphenylsiloxane containing hydrosilyl groups at both ends.

The organopolysiloxane containing hydrogen atoms at both ends has a number average molecular weight of, in view of stability and/or handling ability, for example, 100 to 1,000,000, or preferably 100 to 100,000.

These organohydrogensiloxanes can be used alone or in combination.

Of the organohydrogensiloxanes, preferably, an organopolysiloxane containing a hydrogen atom in its side chain is used, or more preferably, a dimethylpolysiloxane-co-methylhydrogenpolysiloxane is used.

The hydrosilyl group equivalent in the organohydrogensiloxane is, for example, 0.1 mmol/g or more, or preferably 1 mmol/g or more, and is, for example, 30 mmol/g or less, or preferably 20 mmol/g or less.

A commercially available product can be used as the organohydrogensiloxane. An organohydrogensiloxane synthesized in accordance with a known method can be also used.

The mixing ratio of the organohydrogensiloxane with respect to 100 parts by mass of the ethylenic silicon compound is, though depending on the molar ratio of the ethylenically unsaturated hydrocarbon group (R² in the above-described general formula (2)) in the ethylenic silicon compound to the hydrosilyl group (the SiH group) in the organohydrogensiloxane, for example, 10 parts by mass or more, or preferably 100 parts by mass or more, and is, for example, 10,000 parts by mass or less, or preferably 1,000 parts by mass or less.

The molar ratio (R²/SiH) of the ethylenically unsaturated hydrocarbon group (R² in the above-described general formula (2)) in the ethylenic silicon compound to the hydrosilyl group (the SiH group) in the organohydrogensiloxane is, for example, 20/1 or less, preferably 10/1 or less, or more preferably 5/1 or less, and is, for example, 0.05/1 or more, preferably 0.1/1 or more, or more preferably 0.2/1 or more. The above-described molar ratio can be also set to be, for example, less than 1/1 and not less than 0.05/1.

When the molar ratio is above 20/1, there may be a case where a semi-cured material having an appropriate toughness is not obtained when the condensation and addition reaction curable type silicone resin composition is brought into a semi-cured state. On the other hand, when the molar ratio is below 0.05/1, there may be a case where the mixing proportion of the organohydrogensiloxane is excessively large, so that the heat resistance and the toughness of the embedding layer 2 to be obtained are insufficient.

When the molar ratio is less than 1/1 and not less than 0.05/1, in allowing the condensation and addition reaction curable type silicone resin composition to be brought into a semi-cured state, the condensation and addition reaction curable type silicone resin composition can be quickly transferred into a semi-cured state with respect to the condensation and addition reaction curable type silicone resin composition whose molar ratio is 20/1 to 1/1.

The above-described polysiloxane containing silanol groups at both ends, ethylenic silicon compound, epoxy group-containing silicon compound, and organohydrogensiloxane are blended with a catalyst to be stirred and mixed, so that the condensation and addition reaction curable type silicone resin composition is prepared.

Examples of the catalyst include a condensation catalyst and an addition catalyst (a hydrosilylation catalyst).

The condensation catalyst is not particularly limited as long as it is a substance capable of improving the reaction rate of the condensation reaction of the silanol group with the reactive functional group (the SiX¹ group in the above-described general formula (2) and the SiX² group in the above-described general formula (3)). Examples of the condensation catalyst include an acid such as hydrochloric acid, acetic acid, formic acid, and sulfuric acid; a base such as potassium hydroxide, sodium hydroxide, potassium carbonate, and tetramethylammonium hydroxide; and a metal such as aluminum, titanium, zinc, and tin.

These condensation catalysts can be used alone or in combination.

Of the condensation catalysts, in view of compatibility and thermal decomposition properties, preferably, a base is used, or more preferably, tetramethylammonium hydroxide is used.

The mixing ratio of the condensation catalyst with respect to 100 mol of the polysiloxane containing silanol groups at both ends is, for example, 0.1 mol or more, or preferably 0.5 mol or more, and is, for example, 50 mol or less, or preferably 5 mol or less.

The addition catalyst is not particularly limited as long as it is a substance capable of improving the reaction rate of the addition reaction, that is, the hydrosilylation reaction of the ethylenically unsaturated hydrocarbon group with the SiH group. The addition catalyst contains, for example, a transition metal. An example of the transition metal includes an element of the platinum group metal such as platinum, palladium, and rhodium. Preferably, platinum is used.

To be specific, when the addition catalyst contains platinum, examples of the addition catalyst include inorganic platinum such as platinum black, platinum chloride, and chloroplatinic acid and a platinum complex such as a platinum olefin complex, a platinum carbonyl complex, and platinum acetyl acetate. Preferably, a platinum complex is used. To be more specific, examples of the platinum complex include a platinum vinylsiloxane complex, a platinum tetramethyldivinyldisiloxane complex, a platinum carbonylcyclovinylmethylsiloxane complex, a platinum divinyltetramethyldisiloxane complex, a platinum cyclovinylmethylsiloxane complex, and a platinum octanal/octanol complex.

The catalyst has a form in which it is blended distinctively from a silicone resin to be described next and a form in which it is contained in the silicone resin as a component constituting the silicone resin.

These addition catalysts can be used alone or in combination.

Of the addition catalysts, in view of compatibility, transparency, and catalyst activity, preferably, a platinum catalyst is used, or more preferably, a platinum carbonyl complex is used.

The mixing ratio of the addition catalyst, as a number of parts by mass of the metal amount in the addition catalyst, with respect to 100 parts by mass of the organohydrogensiloxane is, for example 1.0 × 10⁻⁴ parts by mass or more, and is, for example, 1.0 part by mass or less, preferably 0.5 parts by mass or less, or more preferably 0.05 parts by mass or less.

As the above-described catalyst, a catalyst in a solid state can be used as it is. Alternatively, in view of handling ability, a catalyst can be also used as a solution or as a dispersion liquid dissolved or dispersed in a solvent.

An example of the solvent includes an organic solvent such as an alcohol including methanol and ethanol; a silicon compound including siloxane (organopolysiloxane and the like); an aliphatic hydrocarbon including hexane; an aromatic hydrocarbon including toluene; and ether including tetrahydrofuran (THF). Also, an example of the solvent includes an aqueous solvent such as water.

As the solvent, when the catalyst is a condensation catalyst, preferably, an alcohol is used and when the catalyst is an addition catalyst, preferably, a silicon compound is used.

In order to prepare the condensation and addition reaction curable type silicone resin composition, for example, the above-described materials (the condensation materials and the addition materials) and the catalysts can be blended simultaneously. Alternatively, each of the materials and each of the catalysts can be added, respectively, at different timings. Furthermore, a part of the components can be added simultaneously and each of the remaining components can be added, respectively, at different timings.

Of the preparing methods of the condensation and addition reaction curable type silicone resin composition, preferably, the following method is used. The condensation materials and the condensation catalyst are first added simultaneously. Next, the addition material is added thereto and thereafter, the addition catalyst is added thereto.

To be specific, the polysiloxane containing silanol groups at both ends, the ethylenic silicon compound, and the epoxy group-containing silicon compound (that is, the condensation materials) are simultaneously blended with the condensation catalyst at the above-described proportion to be stirred for, for example, 5 minutes to 24 hours.

At the time of blending and stirring, the temperature can be also adjusted to be, for example, 0 to 60°C so as to improve the compatibility and the handling ability of the condensation materials.

Thereafter, the pressure in the system (the above-described mixture) is reduced as required, so that a volatile component (an organic solvent) is removed.

Next, the organohydrogensiloxane is blended into the obtained mixture of the condensation materials and the condensation catalyst to be stirred for, for example, 1 to 120 minutes.

At the time of blending and stirring, the temperature can be also adjusted to be, for example, 0 to 60°C so as to improve the compatibility and the handling ability of the mixture and the organohydrogensiloxane.

Thereafter, the addition catalyst is blended into the system (the above-described mixture) to be stirred for, for example, 1 to 60 minutes.

In this way, the condensation and addition reaction curable type silicone resin composition can be prepared.

The prepared condensation and addition reaction curable type silicone resin composition is, for example, in a liquid state (in an oil state). As described later, the prepared condensation and addition reaction curable type silicone resin composition is applied onto the barrier layer 4 to be then heated, so that the condensation materials are subjected to a condensation reaction to be brought into a B-stage state (a semi-cured state). Thereafter, as described later (ref: FIG. 2 (b)), the optical semiconductor element 5 is embedded by the embedding layer 2 to be then heated, so that the addition materials are subjected to an addition reaction to form a condensation and addition reaction curable type silicone resin to be then brought into a C-stage state (a completely cured state) and in this way, the optical semiconductor element 5 is encapsulated.

The mixing ratio of the silicone resin in the encapsulating resin composition is, for example, 70 mass % or more, or preferably 80 mass % or more.

A filler and/or a phosphor (described later) can be also added in the encapsulating resin composition as required.

Examples of the filler include silica (silicon dioxide), barium sulfate, barium carbonate, barium titanate, titanium oxide, zirconium oxide, magnesium oxide, zinc oxide, iron oxide, aluminum hydroxide, calcium carbonate, layered mica, carbon black, diatomite, glass fiber, and silicone resin microparticles.

The filler has an average particle size (the average of the maximum length) of, for example, 0.2 µm or more, or preferably 0.5 µm or more, and of, for example, 40 µm or less, or preferably 10 µm or less. The average particle size is measured with a particle size distribution analyzer.

These fillers can be used alone or in combination.

The phosphor is particles having a wavelength conversion function. The phosphor is not particularly limited as long as it is a known phosphor used in an optical semiconductor device 6 (ref: FIG. 2 (b)). An example of the phosphor includes a known phosphor such as a yellow phosphor that is capable of converting blue light into yellow light and a red phosphor that is capable of converting the blue light into red light.

Examples of the yellow phosphor include a garnet type phosphor having a garnet type crystal structure such as Y₃Al₅O₁₂:Ce (YAG (yttrium aluminum garnet):Ce) and Tb₃Al₃O₁₂:Ce (TAG (terbium aluminum garnet):Ce) and an oxynitride phosphor such as Ca-α-SiAlON.

An example of the red phosphor includes a nitride phosphor such as CaAlSiN₃:Eu and CaSiN₂:Eu.

Of the phosphors, preferably, a yellow phosphor is used, more preferably, Ca-α-SiAlON and YAG:Ce are used, or particularly preferably, YAG:Ce is used.

These phosphors can be used alone or in combination.

The phosphor is in the form of a particle. The shape thereof is not particularly limited and examples of the shape thereof include a generally sphere shape, a generally flat plate shape, and a generally needle shape.

The phosphor has an average particle size (the average of the maximum length) of, for example, 0.1 µm or more, or preferably 0.2 µm or more, and of, for example, 500 µm or less, or preferably 200 µm or less. The average particle size of the phosphor particles is measured with a particle size distribution analyzer.

The degree of whitening is different in accordance with the type of the phosphor, a thickness L1 of the embedding layer 2, and the shape of the encapsulating sheet 1, so that the mixing proportion of the phosphor is not particularly limited. The mixing ratio thereof with respect to the encapsulating resin composition is, for example, 1 mass % or more, or preferably 10 mass % or more, and is, for example, 50 mass % or less, or preferably 40 mass % or less.

Furthermore, a known additive can be added to the above-described encapsulating resin composition at an appropriate proportion as required. Examples of the known additive include antioxidants, modifiers, surfactants, dyes, pigments, discoloration inhibitors, and ultraviolet absorbers.

The encapsulating resin composition is subjected to a defoaming process as required after the preparation thereof.

An example of the defoaming method includes a known defoaming method such as reduced pressure defoaming (vacuum defoaming), centrifugal defoaming, and ultrasonic defoaming. Preferably, reduced pressure defoaming (vacuum defoaming) is used.

When the defoaming method is the reduced pressure defoaming (vacuum defoaming), the defoaming conditions are as follows: a temperature of, for example, 10°C or more, or preferably 15°C or more, and of, for example, 40°C or less, or preferably 35°C or less and a duration of, for example, 10 minutes or more, or preferably 30 minutes or more.

When the embedding layer 2 is formed from an encapsulating resin composition containing a thermosetting resin (preferably, a silicone resin), preferably, the embedding layer 2 is formed in a semi-cured (a B-stage) state.

The thickness L1 of the embedding layer 2 is not particularly limited and is appropriately adjusted so as to be capable of embedding the optical semiconductor element 5 at the time of encapsulation of the optical semiconductor element 5 to be described later (ref: FIG. 2 (b)). To be specific, the embedding layer 2 has the thickness L1 of, for example, 300 µm or more, or preferably 500 µm or more, and of, for example, 3,000 µm or less, or preferably 2,000 µm or less.

The embedding layer 2 may be formed of a single layer or a plurality of layers.

The covering layer 3 is a covering layer that covers the upper surface of the barrier layer 4 to be described in detail next. The covering layer 3 is provided so as to be exposed upwardly in the encapsulating sheet 1.

The covering layer 3 is formed from a transparent resin composition into a generally sheet shape. The transparent resin composition contains, as a main component, the transparent resin illustrated in the embedding layer 2 and contains, as an auxiliary component, a filler and/or a phosphor as required. Preferably, the transparent resin composition that forms the covering layer 3 is formed from an addition reaction curable type silicone resin composition that contains an addition catalyst and a phosphor-containing resin composition that contains a phosphor. As the addition reaction curable type silicone resin composition, a commercially available product (for example, LR7665 manufactured by Wacker Asahikasei Silicone Co., Ltd.: containing a platinum catalyst) can be used or an addition reaction curable type silicone resin composition synthesized in accordance with a known method can be also used. The mixing proportion of the transparent resin (the addition reaction curable type silicone resin composition) in the phosphor-containing resin composition is the same as that of the silicone resin in the encapsulating resin composition illustrated in the embedding layer 2. The content proportion of the filler and the phosphor is the same as the mixing proportion of those in the encapsulating resin composition illustrated in the embedding layer 2.

The covering layer 3 has a thickness of, for example, 10 µm or more, or preferably 50 µm or more, and of, for example, 1,000 µm or less, or preferably 500 µm or less.

The barrier layer 4 is, in the thickness direction, provided so as to be sandwiched between the embedding layer 2 and the covering layer 3. The barrier layer 4 is formed into a generally rectangular flat plate shape extending in the plane direction. The embedding layer 2 is provided on the entire lower surface of the barrier layer 4 and the covering layer 3 is provided on the entire upper surface of the barrier layer 4.

The barrier layer 4 is, for example, a barrier film so as to suppress a transfer (migration) of a component contained in the covering layer 3 to the embedding layer 2.

To be specific, an example of the component serving as an object in which the transfer to the embedding layer 2 is suppressed by the barrier layer 4 includes a catalyst contained in the covering layer 3. To be more specific, an addition catalyst is used, or specifically, a hydrosilylation catalyst is used.

Furthermore, the barrier layer 4 is also a layer having an excellent mechanical strength.

The barrier layer 4 is, for example, formed of a glass or the like.

The glass is not particularly limited and examples thereof include a non-alkali glass, a soda glass, a silica glass, a borosilicate glass, a lead glass, and a fluoride glass. Also, an example of the glass includes a heat-resisting glass. To be specific, examples thereof include commercially available products known as a trade name such as TEMPAX glass, Vycor glass, or Pyrex glass. As the glass, preferably, a non-alkali glass and a soda glass are used.

The barrier layer 4 has a thickness of 50 µm or more and 1,000 µm or less. The barrier layer 4 has a thickness of preferably 75 µm or more, more preferably 100 µm or more, or further more preferably 150 µm or more, and of preferably 750 µm or less, or more preferably 500 µm or less.

When the thickness of the barrier layer 4 is below the above-described lower limit, the barrier properties of the encapsulating sheet 1 with respect to the transfer are not capable of being improved and an excellent mechanical strength is not capable of being imparted to the encapsulating sheet 1. Thus, the strength and the barrier properties of the optical semiconductor device 6 (ref: FIG. 2 (b)) are not capable of being sufficiently improved.

On the other hand, when the thickness of the barrier layer 4 is above the above-described upper limit, the thinning of the encapsulating sheet 1 is not capable of being achieved. Then, the thinning of the optical semiconductor device 6 (ref: FIG. 2 (b)) is also not capable of being achieved.

The ratio ([a thickness L2 of the barrier layer 4] / [the thickness L1 of the embedding layer 2]) of the thickness L2 of the barrier layer 4 to the thickness L1 of the embedding layer 2 is, for example, 0.10 or more, preferably 0.15 or more, more preferably 0.20 or more, further more preferably 0.30 or more, or particularly preferably 0.50 or more, and is, for example, 2.00 or less, preferably 1.00 or less, or more preferably 0.90 or less.

When the above-described ratio (L2/L1) is below the above-described lower limit, there may be a case where the barrier layer 4 is excessively thin with respect to the embedding layer 2, so that the gas barrier properties of the encapsulating sheet 1 are insufficient and the strength of the encapsulating sheet 1 is insufficient and thus, an excellent mechanical strength and the gas barrier properties are not capable of being imparted to the optical semiconductor device 6. Or, there may be a case where the embedding layer 2 is excessively thick with respect to the barrier layer 4, so that the thickness of the encapsulating sheet 1 is excessively thick and thus, the thinning of the optical semiconductor device 6 is not capable of being achieved.

On the other hand, when the above-described ratio (L2/L1) is above the above-described upper limit, there may be a case where the barrier layer 4 is excessively thick with respect to the embedding layer 2, so that the thinning of the encapsulating sheet 1 is not capable of being achieved. Or, there may be a case where the embedding layer 2 is excessively thin with respect to the barrier layer 4, so that the optical semiconductor element 5 is not capable of being surely embedded; thus, the optical semiconductor element 5 is not capable of being encapsulated; and as a result, the reliability of the optical semiconductor device 6 is reduced.

The barrier layer 4 has a radius of curvature measured by a bending test of, for example, 1,000 mm or less, or preferably 500 mm or less, and of, for example, 10 mm or more, or preferably 50 mm or more. When the radius of curvature of the barrier layer 4 is above the above-described upper limit, there may be a case where the flexibility of the barrier layer 4 is low and thus, an excellent mechanical strength is not capable of being imparted to the optical semiconductor device 6. When the radius of curvature of the barrier layer 4 is below the above-described lower limit, there may be a case where the barrier layer 4 is excessively flexible, so that an excellent mechanical strength is not capable of being imparted to the optical semiconductor device 6.

The encapsulating sheet 1 has a thickness of, for example, 100 µm or more, preferably 150 µm or more, or more preferably 200 µm or more, and of, for example, 5,000 µm or less, preferably 2,500 µm or less, more preferably 2,000 µm or less, or further more preferably 1,500 µm or less.

When the thickness of the encapsulating sheet 1 is not more than the above-described upper limit, the thinning of the optical semiconductor device 6 is capable of being achieved.

Next, a method for producing the encapsulating sheet 1 shown in FIG. 1 is described.

In this method, first, the barrier layer 4 is prepared. The barrier layer 4 is, for example, prepared by being trimmed into a generally rectangular flat plate shape having an appropriate dimension in advance.

Next, the covering layer 3 is formed on the barrier layer 4.

Examples of a method for forming the covering layer 3 on the barrier layer 4 include a method in which the covering layer 3 is directly formed on the barrier layer 4 and a method in which after forming the covering layer 3 on another release film or the like, the covering layer 3 is transferred from the release film onto the barrier layer 4 by a laminator, a thermal compression bonding, or the like.

Preferably, the embedding layer 2 is directly formed on the barrier layer 4.

To be specific, an encapsulating resin composition, or preferably a phosphor-containing resin composition is applied to the entire upper surface of the barrier layer 4 by, for example, a known application method such as a casting, a spin coating, and a roll coating.

When the phosphor-containing resin composition contains a thermosetting resin, the phosphor-containing resin composition is heated and dried, so that the covering layer 3 is brought into a B-stage state (a semi-cured state) or the covering layer 3 is brought into a C-stage state (a completely cured state) via a B-stage state. Preferably, the covering layer 3 is brought into a C-stage state. In this way, the covering layer 3 is formed from the thermosetting resin in a C-stage state.

In order to bring the covering layer 3 into a C-stage state, subsequently, the applied encapsulating resin composition (preferably, the phosphor-containing resin composition) is heated.

The heating conditions are as follows: a temperature of, for example, 50°C or more, or preferably 80°C or more, and of, for example, 150°C or less, or preferably 140°C or less and a heating duration of, for example, 1 minute or more, or preferably 5 minutes or more, and of, for example, 100 minutes or less, or preferably 15 minutes or less. Whether the barrier layer 4 is in a C-stage state or not can be appropriately set in accordance with the type of the thermosetting resin.

The covering layer 3 immediately after being produced has a compressive elastic modulus at 25°C of, for example, 0.001 MPa or more, or preferably 0.01 MPa or more, and of, for example, 10 MPa or less, or preferably 5 MPa or less.

Next, the barrier layer 4 on which the covering layer 3 is laminated is reversed upside down and the embedding layer 2 is formed on (in FIG. 1, for convenience, illustrated as "below") the barrier layer 4.

Examples of a method for forming the embedding layer 2 on the barrier layer 4 include a method in which the embedding layer 2 is directly formed on the barrier layer 4 and a method in which after forming the embedding layer 2 on another release film or the like, the embedding layer 2 is transferred from the release film onto the barrier layer 4 by a laminator, a thermal compression bonding, or the like.

Preferably, the embedding layer 2 is directly formed on the barrier layer 4.

In order to form the embedding layer 2 directly on the barrier layer 4, for example, an encapsulating resin composition is applied to the entire upper surface of the barrier layer 4 by, for example, a known application method such as a casting, a spin coating, and a roll coating.

In this way, the embedding layer 2 is formed on the barrier layer 4.

When the encapsulating resin composition contains a thermosetting resin, the embedding layer 2 is heated and the embedding layer 2 that is prepared from the encapsulating resin composition is brought into a B-stage state (a semi-cured state).

The heating conditions are as follows: a temperature of, for example, 50°C or more, or preferably 80°C or more, and of, for example, 150°C or less, or preferably 140°C or less and a heating duration of, for example, 1 minute or more, or preferably 5 minutes or more, and of, for example, 100 minutes or less, or preferably 15 minutes or less. Whether the embedding layer 2 is in a B-stage state or not can be appropriately set in accordance with the type of the thermosetting resin.

In this way, the encapsulating sheet 1 including the barrier layer 4, the covering layer 3 that is laminated thereon, and the embedding layer 2 that is laminated on the barrier layer 4 is obtained.

The embedding layer 2 in the encapsulating sheet 1 immediately after being fabricated has an elastic modulus at 25°C of, for example, 40 kPa or more, or preferably 60 kPa or more, and of, for example, 500 kPa or less, or preferably 300 kPa or less. The elastic modulus is measured using a nanoindenter. The measurement conditions of the elastic modulus are described in detail in Examples to be described later.

Next, a method for producing the optical semiconductor device 6 by encapsulating the optical semiconductor element 5 using the above-described encapsulating sheet 1 is described with reference to FIG. 2.

In this method, first, as shown in FIG. 2 (a), a substrate 8 on which the optical semiconductor element 5 is mounted is prepared.

The substrate 8 is formed into a generally flat plate shape. To be specific, the substrate 8 is formed of a laminated substrate in which a conductive layer (not shown) provided with an electrode pad (not shown) and a wire (not shown) is laminated, as a circuit pattern, on an insulating substrate. The insulating substrate is formed of, for example, a silicon substrate, a ceramic substrate, a polyimide resin substrate, or the like. Preferably, the insulating substrate is formed of a ceramic substrate, to be specific, a sapphire substrate.

The conductive layer is formed of, for example, a conductor such as gold, copper, silver, or nickel. The substrate 8 has a thickness of, for example, 30 µm or more, or preferably 50 µm or more, and of, for example, 1,500 µm or less, or preferably 1,000 µm or less.

The optical semiconductor element 5 is provided on the upper surface of the substrate 8. The optical semiconductor element 5 is wire-bonding connected to the electrode pad in the substrate 8 via a wire 7 and in this way, is electrically connected to the conductive layer. The optical semiconductor element 5 is, for example, an element (to be specific, a blue LED) that emits blue light. An electrode that is not shown is formed on the upper surface of the optical semiconductor element 5. The optical semiconductor element 5 has a length (a thickness) L3 in the up-down direction of, for example, 10 to 1,000 µm.

The wire 7 is formed into a linear shape. One end thereof is electrically connected to a terminal in the optical semiconductor element 5 and the other end thereof is electrically connected to an electrode pad (not shown) in the substrate 8.

As a material of the wire 7, a metal material used as a wire-bonding material of the optical semiconductor element 5 is used. Examples of the metal material include gold, silver and copper. In view of corrosion resistance, preferably, gold is used.

The wire 7 has a wire diameter (a thickness) of, for example, 10 µm or more, or preferably 20 µm or more, and of, for example, 100 µm or less, or preferably 50 µm or less.

The wire 7 is curved or bent in a state where it connects the optical semiconductor element 5 to the substrate 8 and is formed into a generally arch shape (for example, a triangular arch shape, a quadrangular arch shape, a circular arch shape, or the like).

The wire 7 has a length L4 between one end (the upper surface of the terminal in the optical semiconductor element 5) thereof and a portion that is positioned at the uppermost side (that is, the uppermost end portion) of, for example, 100 µm or more, or preferably 150 µm or more, and of, for example, 2,000 µm or less, or preferably 1,000 µm or less.

The wire 7 has a length L5 between the other end (the upper surface of the electrode pad in the substrate 8) thereof and the uppermost end portion (that is, the height of the wire 7) of, for example, 100 µm or more, or preferably 300 µm or more, and of, for example, 1,000 µm or less, or preferably 500 µm or less. The height L5 of the wire 7 with respect to the thickness L3 of the optical semiconductor element 5 is, for example, one and a half times or more, preferably twice or more, and is, for example, 10 times or less, or preferably 5 times or less.

The wire 7 has a length D in the right-left direction between both ends thereof of, for example, 0.1 mm or more, or preferably 0.3 mm or more, and of, for example, 3 mm or less, or preferably 2 mm or less. When the length D in the right-left direction between both ends of the wire 7 is not less than the above-described lower limit, a reduction in the accuracy of the wire bonding is capable of being effectively prevented. When the length D in the right-left direction between both ends of the wire 7 is not more than the above-described upper limit, a deformation of the wire 7 is capable of being effectively suppressed.

Next, as shown in FIG. 2 (a), the encapsulating sheet 1 is disposed in opposed relation to the upper side of the substrate 8. To be specific, the embedding layer 2 in the encapsulating sheet 1 is disposed above the substrate 8 so as to be opposed to the optical semiconductor element 5.

Next, as shown in FIG. 2 (b), the optical semiconductor element 5 is embedded by the embedding layer 2 in the encapsulating sheet 1.

To be specific, the encapsulating sheet 1 is subjected to a thermal compression bonding with respect to the substrate 8.

Preferably, the encapsulating sheet 1 and the substrate 8 are flat plate pressed to each other.

The pressing conditions are as follows: a temperature of, for example, 80°C or more, or preferably 100°C or more, and of, for example, 220°C or less, or preferably 200°C or less and a pressure of, for example, 0.01 MPa or more, and of, for example, 1 MPa or less, or preferably 0.5 MPa or less. The pressing duration is, for example, 1 to 10 minutes.

By the thermal compression bonding, the upper surface and the side surfaces of the optical semiconductor element 5 are covered with the embedding layer 2. That is, the optical semiconductor element 5 is embedded by the embedding layer 2.

A portion that is exposed from the optical semiconductor element 5 on the upper surface of the substrate 8 is covered with the embedding layer 2.

In this way, the encapsulating sheet 1 is allowed to adhere to the optical semiconductor element 5 and the substrate 8.

By the thermal compression bonding, when the encapsulating resin composition in the embedding layer 2 and/or the covering layer 3 contains a thermosetting resin, the covering layer 3 and/or the embedding layer 2 are/is brought into a C-stage state (a completely cured state). In a case where the covering layer 3 is already formed from the encapsulating resin composition into a C-stage state, when the encapsulating resin composition in the embedding layer 2 contains a thermosetting resin in a B-stage state, the embedding layer 2 is brought into a C-stage state (a completely cured state) by the thermal compression bonding.

In this way, the optical semiconductor device 6 in which the optical semiconductor element 5 is encapsulated by the embedding layer 2 and the barrier layer 4 is protected by the covering layer 3 is obtained.

When the covering layer 3 and/or the embedding layer 2 contain(s) a phosphor and the optical semiconductor element 5 is a blue LED, the optical semiconductor device 6 is obtained as a white light emitting device.

That is, the optical semiconductor device 6 is provided with the substrate 8, the optical semiconductor element 5 that is mounted on the substrate 8, and the encapsulating sheet 1 that is formed on the substrate 8 and encapsulates the optical semiconductor element 5. The arrangement is made so that the embedding layer 2 embeds the optical semiconductor element 5; the covering layer 3 is exposed upwardly in the optical semiconductor device 6; and the barrier layer 4 is interposed between the embedding layer 2 and the covering layer 3.

When the optical semiconductor element 5 is encapsulated by the encapsulating sheet 1, the optical semiconductor element 5 is capable of being collectively encapsulated, so that the optical semiconductor device 6 is capable of being obtained with excellent production efficiency. The encapsulating sheet 1 includes the barrier layer 4 having a thickness of 50 µm or more and 1,000 µm or less so as to suppress the transfer of the component contained in the covering layer 3 to the embedding layer 2, so that the transfer of the component contained in the covering layer 3 to the embedding layer 2 is suppressed and the curing of the embedding layer 2 before embedding the optical semiconductor element 5 is capable of being suppressed.

That is, the encapsulating sheet 1 has the above-described compressive elastic modulus, that is, includes the covering layer 3 having high hardness and the embedding layer 2 that is in a gel state so as to encapsulate the optical semiconductor element 5, so that the movement of the component contained in the covering layer 3 through the encapsulating sheet 1, to be more specific, the transfer thereof to the embedding layer 2 is suppressed by the barrier layer 4 having the above-described specific thickness. In this way, the excellent toughness is ensured by the covering layer 3 and the migration of the above-described component is prevented by the barrier layer 4, so that the optical semiconductor element 5 is capable of being surely embedded.

Thus, a gelled state (a B-stage state) of the covering layer 3 is capable of being retained for a long period of time, so that the preservability of the encapsulating sheet 1 is excellent.

To be more specific, in a case where the covering layer 3 is formed from an addition reaction curable type silicone resin composition having a catalyst (to be specific, an addition catalyst) and the embedding layer 2 is formed from a condensation and addition reaction curable type silicone resin composition in a B-stage state, there may be a case where the catalyst in the covering layer 3 is transferred to the embedding layer 2 in a B-stage state without the barrier layer 4, so that the embedding layer 2 is brought into a C-stage state (a completely cured state) before embedding the optical semiconductor element 5. Then, subsequently, when the optical semiconductor element 5 is attempted to be embedded in the embedding layer 2, there may be a case where a damage to the optical semiconductor element 5, or furthermore, a deformation and damage of the wire 7 is not capable of being suppressed.

On the other hand, in the embodiment, by the embedding layer 2 before curing in which the transfer of the component in the covering layer 3 to the embedding layer 2 is suppressed by the barrier layer 4, the optical semiconductor element 5 and the wire 7 are capable of being surely embedded, while a damage to the optical semiconductor element 5 and the wire 7 is suppressed. Thereafter, when the embedding layer 2 is cured, the optical semiconductor element 5 and the wire 7 are capable of being surely encapsulated. Thus, the optical semiconductor device 6 having excellent dimension stability is capable of being obtained.

In addition, in the encapsulating sheet 1, the barrier layer 4 has a thickness of 50 µm or more and 1,000 µm or less, so that an excellent strength is ensured and the thinning of the encapsulating sheet 1 is capable of being achieved, while the barrier properties of suppressing the transfer of the component contained in the covering layer 3 to the embedding layer 2 are excellent. Thus, when the optical semiconductor element 5 is encapsulated by the encapsulating sheet 1, the strength and the reliability of the optical semiconductor device 6 are capable of being improved even with the thin encapsulating sheet 1.

In the encapsulating sheet 1, when the embedding layer 2 is formed from a thermosetting resin in a B-stage state, the optical semiconductor element 5 is capable of being surely embedded by the flexible embedding layer 2. When the covering layer 3 is formed from a thermosetting resin in a C-stage state, the strength of the encapsulating sheet 1 is capable of being further improved.

Furthermore, in the encapsulating sheet 1, the ratio (L2/L1) of the thickness L2 of the barrier layer 4 to the thickness L1 of the embedding layer 2 is 0.10 or more and 1.00 or less, so that an excellent strength is ensured and the thinning of the encapsulating sheet 1 is capable of being achieved, while the barrier properties with respect to the transfer of the component contained in the covering layer 3 to the embedding layer 2 are excellent. Thus, when the optical semiconductor element 5 is encapsulated by the encapsulating sheet 1, the strength and the reliability of the optical semiconductor device 6 are capable of being improved even with the thin encapsulating sheet 1.

### <Modified Example>

In the embodiment in FIG. 2, the optical semiconductor element 5 is wire-bonding connected to the substrate 8 via the wire 7. Alternatively, for example, though not shown, the optical semiconductor element 5 is also capable of being flip-chip mounted on the substrate 8 without using the wire 7.

In the above-described embodiment, in the method for producing the encapsulating sheet 1, first, the covering layer 3 is laminated on the barrier layer 4 and thereafter, the resulting product is reversed upside down, so that the embedding layer 2 is formed on the barrier layer 4. Alternatively, for example, oppositely, to be specific, the embedding layer 2 is first laminated on the barrier layer 4 and thereafter, the resulting product is reversed upside down, so that the covering layer 3 is also capable of being formed on the barrier layer 4.

Also, the barrier layer 4 in a flat plate shape is not prepared in advance by being trimmed and the barrier layer 4 is capable of being formed on the embedding layer 2 or the covering layer 3 by, for example, applying a glass composition containing a material that forms the barrier layer 4 onto the embedding layer 2 or the covering layer 3 to be thereafter being sintered by heating. An example of the glass composition includes a slurry solution described in Japanese Unexamined Patent Publication No. 2012-129361 or the like.

In the above-described description, the encapsulating sheet 1 is formed into a generally rectangular shape in plane view. However, the shape of the encapsulating sheet 1 in plane view is not limited to this and can be appropriately changed as required. To be specific, the encapsulating sheet 1 can be, for example, formed into a generally circular shape in plane view or the like.

### Examples

The values to be described in Examples shown in the following can be replaced with the values described in the embodiments, that is, the upper limit value or the lower limit value.

### <Preparation of Silicone Resin Composition A>

### Prepared Example 1

As an ethylenically unsaturated hydrocarbon group-containing silicon compound, 15.76 g (0.106 mol) of a vinyltrimethoxysilane and as an ethylenically unsaturated hydrocarbon group-containing silicon compound, 2.80 g (0.0118 mol) [the ratio [SiOH/(SiX¹ + SiX²) = 1/1] of the number of moles of the SiOH group in the polydimethylsiloxane containing silanol groups at both ends to the total number of moles of the SiX¹ group in the ethylenically unsaturated hydrocarbon group-containing silicon compound and the SiX² group in the ethylenically unsaturated hydrocarbon group-containing silicon compound] of a (3-glycidoxypropyl)trimethoxysilane were stirred and mixed into 2,031 g (0.177 mol) of a polydimethylsiloxane containing silanol groups at both ends [a compound in which all of the R¹s are methyl groups and "n"=155 in the following formula (1), a number average molecular weight of 11,500] that was heated at 40°C. Thereafter, as a condensation catalyst, 0.97 mL (an amount of catalyst: 0.88 mol, 0.50 mol with respect to 100 mol of the polydimethylsiloxane containing silanol groups at both ends) of a methanol solution (a concentration of 10 mass %) of tetramethylammonium hydroxide was added thereto to be stirred at 40°C for one hour. The obtained oil was stirred under a reduced pressure (10 mmHg) at 40°C for one hour and a volatile component was removed. Next, the pressure of the reaction liquid (the oil) was brought back to a normal pressure and then, an organohydrogenpolysiloxane (a dimethylpolysiloxane-co-methylhydrogenpolysiloxane) was added thereto so that the molar ratio of the vinyl group to the hydrosilyl group was SiR²/SiH = 1/3.0, and then, the obtained mixture was stirred at 40°C for one hour. Thereafter, as a hydrosilylation catalyst, 0.038 mL (the platinum content of 0.375 ppm with respect to the organopolysiloxane) of a platinum carbonyl complex (a platinum concentration of 2.0 mass %) was added to obtained mixture to be stirred at 40°C for 10 minutes, so that a mixture (an oil) was obtained.

Formula (1):

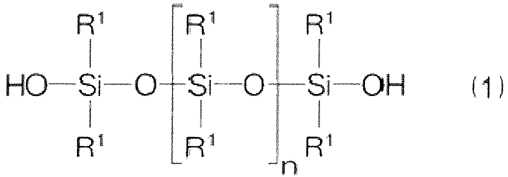

The mixture was defined as a silicone resin composition A (a non-phosphor containing resin composition).

### <Preparation of Silicone Resin Composition B>

### Prepared Example 2

As a phosphor, 20 g of YAG:Ce (an average particle size of 8.9 µm) was added to 80 g of the mixture (the oil, the silicone resin composition A) that was obtained in Prepared Example 1 to be stirred at a room temperature (20°C) for 10 minutes. After the stirring, the obtained mixture was subjected to a defoaming process under a reduced pressure with a vacuum dryer at a room temperature for 30 minutes or more.

In this way, a silicone resin composition B (a phosphor-containing resin composition) was prepared (YAG:Ce content of 20 mass %).

### <Preparation of Silicone Resin Composition C>

### Prepared Example 3

20 g of YAG:Ce (an average particle size of 8.9 µm) was mixed into 80 g of a liquid mixture (a mixing ratio (A/B) = 1/1) in which an A liquid and a B liquid of an addition reaction curable type silicone resin composition (LR7665, manufactured by Wacker Asahikasei Silicone Co., Ltd.) were mixed to be stirred for one hour. After the stirring, the obtained mixture was subjected to a defoaming process under a reduced pressure with a vacuum dryer at a room temperature for 30 minutes or more.

In this way, a silicone resin composition C (a phosphor-containing resin composition) was prepared (a phosphor concentration of 20 mass %).

### <Preparation of Silicone Resin Composition D>

### Prepared Example 4

A liquid mixture (a mixing ratio (A/B) = 1/1) in which an A liquid and a B liquid of an addition reaction curable type silicone resin composition (LR7665, manufactured by Wacker Asahikasei Silicone Co., Ltd.) were mixed was defined as a silicone resin composition D (a non-phosphor containing resin composition).

### (Fabrication of Encapsulating Sheet and Fabrication of Optical Semiconductor Device)

### Example 1

First, a non-alkali glass was prepared as a barrier layer. The barrier layer had a thickness of 200 µm and a size of 10 mm × 10 mm.

Next, the silicone resin composition C (the phosphor-containing resin composition) in Prepared Example 3 was applied onto the non-alkali glass so that the thickness L2 in a C-stage state was 400 µm to be dried at 100°C for 10 minutes and in this way, an embedding layer in a C-stage state was formed.

Thereafter, the embedding layer and the barrier layer were reversed upside down and the silicone resin composition C (the phosphor-containing resin composition) in Prepared Example 3 was applied onto the barrier layer so that the thickness L1 in a C-stage state was 600 µm to be dried at 135°C for 10 minutes and in this way, the embedding layer in a R-stage state was formed.

In this way, an encapsulating sheet including the covering layer, the embedding layer, and the barrier layer that was interposed therebetween was obtained.

### Example 2

An encapsulating sheet was obtained and subsequently, an optical semiconductor device was fabricated in the same manner as in Example 1, except that the thickness L2 of the barrier layer was changed from 200 µm to 500 µm.

### Example 3

An encapsulating sheet was obtained and subsequently, an optical semiconductor device was fabricated in the same manner as in Example 1, except that as a barrier layer, a soda glass (a size of 10 mm × 10 mm) having the thickness L2 of 500 µm was used instead of the non-alkali glass having the thickness L2 of 200 µm.

### Example 4

An encapsulating sheet was obtained and subsequently, an optical semiconductor device was fabricated in the same manner as in Example 1, except that in the formation of the covering layer, the silicone resin composition D (the non-phosphor containing resin composition) in Prepared Example 4 was used instead of the silicone resin composition C (the phosphor-containing resin composition) in Prepared Example 3 and furthermore, in the formation of the embedding layer, the silicone resin composition B (the phosphor-containing resin composition) in Prepared Example 2 was used instead of the silicone resin composition A (the non-phosphor containing resin composition) in Prepared Example 1.

### Example 5

An encapsulating sheet was obtained and subsequently, an optical semiconductor device was fabricated in the same manner as in Example 1, except that the thickness L2 of the barrier layer was changed from 200 µm to 50 µm.

### Example 6

An encapsulating sheet was obtained and subsequently, an optical semiconductor device was fabricated in the same manner as in Example 3, except that the thickness L2 of the barrier layer was changed from 500 µm to 50 µm.

### Example 7

An encapsulating sheet was obtained and subsequently, an optical semiconductor device was fabricated in the same manner as in Example 1, except that the thickness L2 of the barrier layer was changed from 200 µm to 1,000 µm.

### Example 8

An encapsulating sheet was obtained and subsequently, an optical semiconductor device was fabricated in the same manner as in Example 3, except that the thickness L2 of the barrier layer was changed from 500 µm to 1,000 µm.

### Comparative Example 1

An encapsulating sheet was obtained and subsequently, an optical semiconductor device was fabricated in the same manner as in Example 1, except that the encapsulating sheet was formed of the embedding layer and the covering layer without including the barrier layer.

That is, in the encapsulating sheet, the silicone resin composition A in Prepared Example 1 was applied onto a release sheet so that the thickness L1 in a C-stage state was 600 µm to be dried at 135°C for 10 minutes and in this way, the embedding layer in a B-stage state was formed.

Separately, the silicone resin composition C (the phosphor-containing resin composition) in Prepared Example 3 was applied onto the release sheet so that the thickness in a C-stage state was 400 µm to be dried at 100°C for 10 minutes and in this way, the covering layer in a C-stage state was formed.

Thereafter, the embedding layer and the covering layer were attached to each other.

In this way, the encapsulating sheet including the embedding layer and the covering layer was obtained.

Next, a substrate on which an optical semiconductor element was mounted was prepared. In the substrate, an electrode pad that was made of silver was formed and the optical semiconductor element was electrically connected to the substrate by the electrode pad.

Thereafter, the encapsulating sheet was disposed with respect to the substrate so that the embedding layer was opposed to the optical semiconductor element.

Subsequently, by flat plate pressing, the encapsulating sheet was subjected to a thermal compression bonding under the pressing conditions of 160°C, five minutes, and 0.1 MPa, so that the optical semiconductor element was encapsulated. By the thermal compression bonding, the embedding layer was brought into a C-stage state. Thereafter, the release sheet was peeled from the embedding layer.

In this way, the optical semiconductor device in which the optical semiconductor element was encapsulated by the encapsulating sheet was fabricated.

### Comparative Example 2

An encapsulating sheet was obtained and subsequently, an optical semiconductor device was fabricated in the same manner as in Example 1, except that the thickness L2 of the barrier layer was changed from 200 µm to 35 µm.

### Comparative Example 3

An encapsulating sheet was obtained and subsequently, an optical semiconductor device was fabricated in the same manner as in Example 3, except that the thickness L2 of the barrier layer was changed from 500 µm to 35 µm.

### Comparative Example 4

An encapsulating sheet was obtained and subsequently, an optical semiconductor device was fabricated in the same manner as in Example 1, except that the thickness L2 of the barrier layer was changed from 200 µm to 2,000 µm.

### Comparative Example 5

An encapsulating sheet was obtained and subsequently, an optical semiconductor device was fabricated in the same manner as in Example 3, except that the thickness L2 of the barrier layer was changed from 500 µm to 2,000 µm.

### (Evaluation)

### 1. Measurement of Radius of Curvature of Barrier Layer

The radius of curvature of each of the barrier layers used in Examples and Comparative Examples was measured.

The radius of curvature was measured by a bending test.

The results are shown in Tables 1 and 2.

### 2. Elastic Modulus of Embedding Layer

The elastic modulus of each of the embedding layers immediately after being fabricated and after being stored at 5°C for one month in Examples and Comparative Examples was measured.

To be specific, the elastic modulus of the embedding layer in a B-stage state was measured using a nanoindenter at 25°C.

The results are shown in Tables 1 and 2.

### 3. Mechanical Strength of Encapsulating Sheet

The mechanical strength of each of the encapsulating sheets in Examples and Comparative Examples was evaluated by a drop test.

To be specific, the encapsulating sheet was allowed to fall from the height of 1,000 mm to observe the presence or absence of a fracture (a damage) of the barrier layer, so that the mechanical strength of the encapsulating sheet was evaluated.

The results are shown in Tables 1 and 2.

### 4. Encapsulating Properties of Optical Semiconductor Element and Wire

An optical semiconductor element in a rectangular shape in plane view that was mounted on a substrate by a wire-bonding connection with a wire was prepared (ref: FIG. 2 (a)). The dimension of the optical semiconductor element and the wire was as follows.

Thickness L3 of the optical semiconductor element: 150 µm

Wire diameter of the wire: 30 µm

Height L4 of the wire: 450 µm

Length D in the right-left direction between both ends of the wire: 2,000 µm

Subsequently, the optical semiconductor element and the wire were encapsulated by each of the encapsulating sheets that was stored at 5°C for one month after being fabricated in Examples and Comparative Examples.

To be specific, the encapsulating sheet was disposed at the upper side of the substrate so that the embedding layer was opposed to the optical semiconductor element and subsequently, the encapsulating sheet was pushed down, so that the optical semiconductor element and the wire were embedded by the embedding layer. In this way, the optical semiconductor device was obtained.

The wire of the obtained optical semiconductor device was observed and the encapsulating properties with respect to the wire were evaluated.

The results are shown in Tables 1 and 2.

Table 1

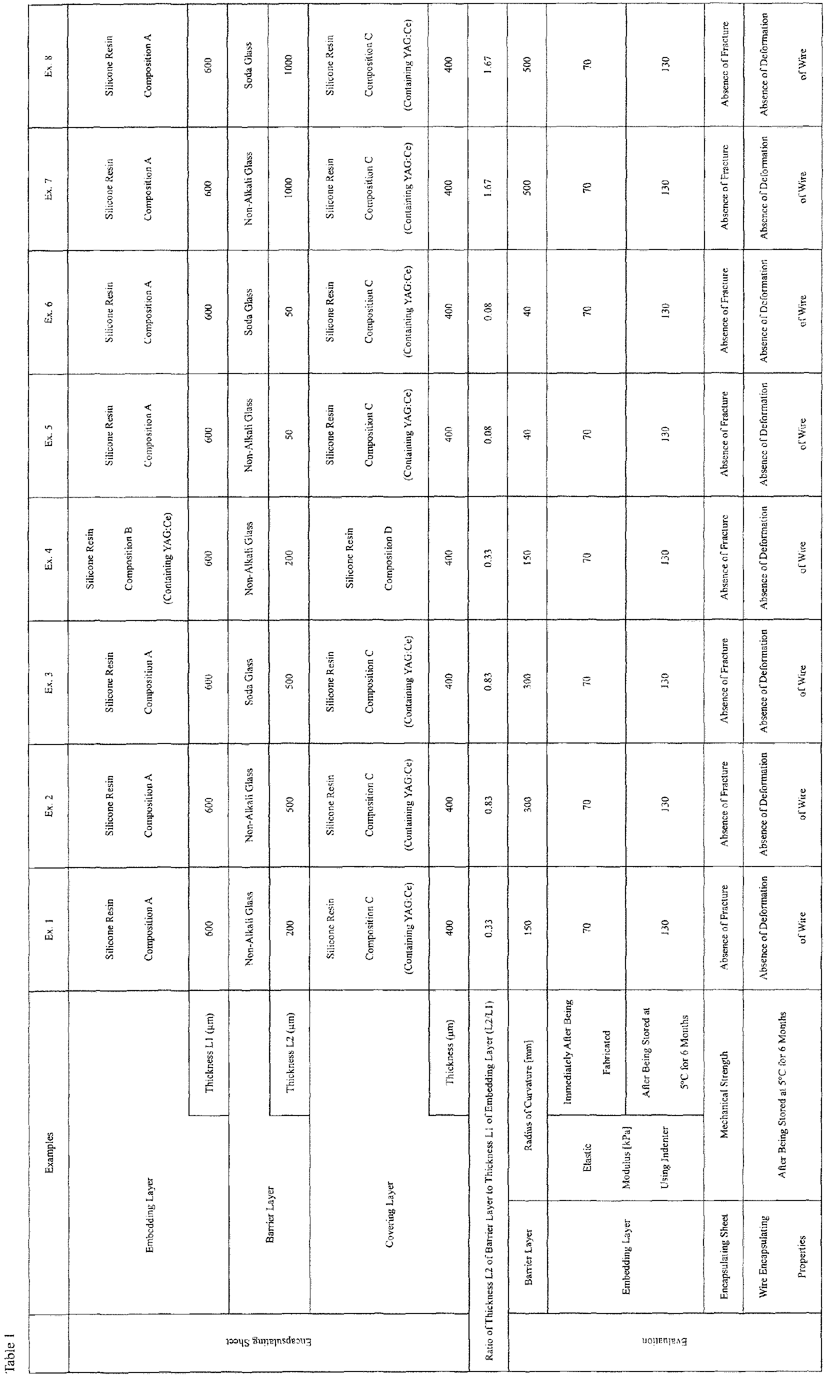

Table 2

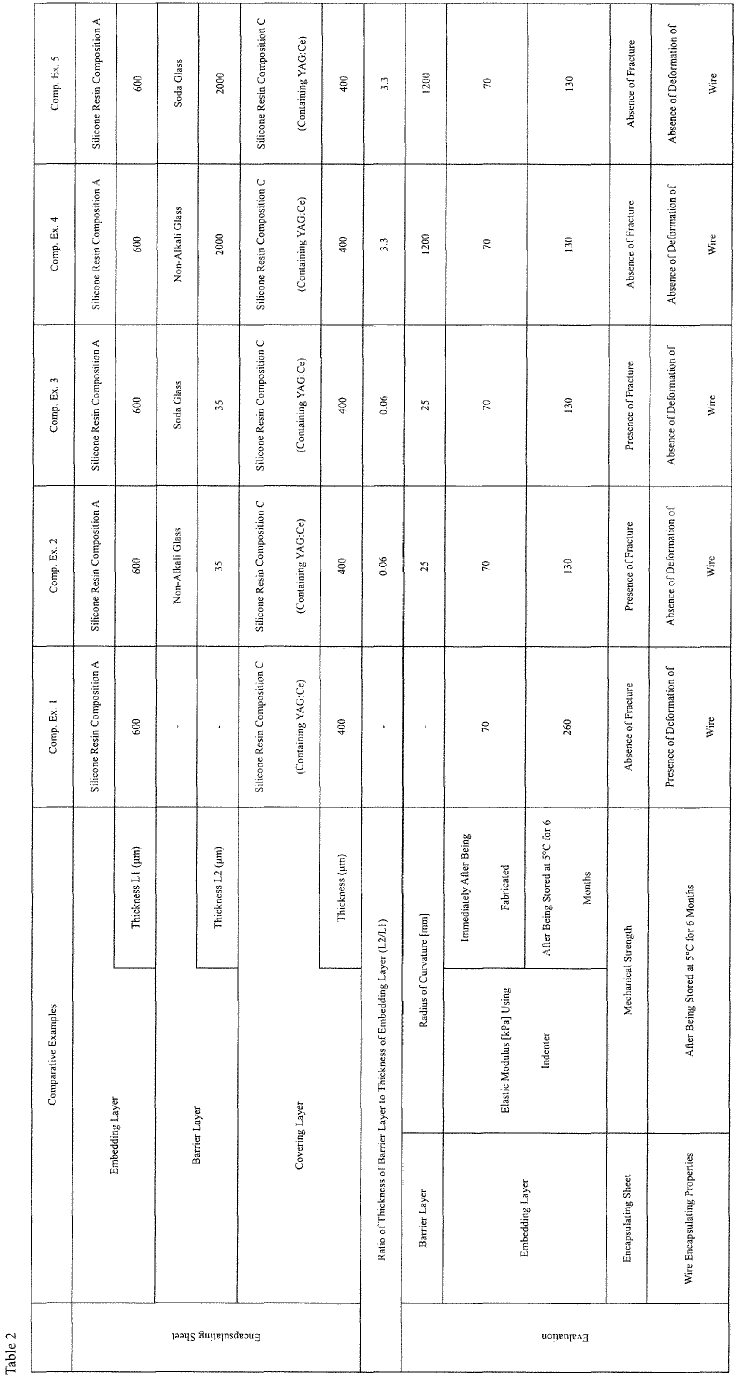

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

## Claims

1. An encapsulating sheet, for encapsulating an optical semiconductor element, comprising:
an embedding layer for embedding the optical semiconductor element,
a covering layer disposed at one side in a thickness direction with respect to the embedding layer, and
a barrier layer interposed between the embedding layer and the covering layer; having a thickness of 50 µm or more and 1,000 µm or less; and for suppressing a transfer of a component contained in the covering layer to the embedding layer.

2. The encapsulating sheet according to claim 1, wherein
the embedding layer is formed from a thermosetting resin in a B-stage state and
the covering layer is formed from a thermosetting resin in a C-stage state.

3. The encapsulating sheet according to claim 1 or 2, wherein
the ratio of the thickness of the barrier layer to that of the embedding layer is 0.10 or more and 1.00 or less.
